Europäisches Patentamt

European Patent Office

Office européen des brevets

(11) Veröffentlichungsnummer: **0 497 183 A2**

# (12) EUROPÄISCHE PATENTANMELDUNG

(21) Anmeldenummer: **92100887.6**

(22) Anmeldetag: **20.01.92**

(51) Int. Cl.⁵: **H01L 39/02**, H01L 39/24

(30) Priorität: **31.01.91 DE 4102891**

(43) Veröffentlichungstag der Anmeldung:
**05.08.92 Patentblatt 92/32**

(84) Benannte Vertragsstaaten:
**DE FR GB IT NL**

(71) Anmelder: **SIEMENS AKTIENGESELLSCHAFT**
**Wittelsbacherplatz 2**
**W-8000 München 2(DE)**

(72) Erfinder: **Uhl, Dieter, Dipl.-Ing. (FH)**
**Sudetenstrasse 5**
**W-8525 Uttenreuth(DE)**
Erfinder: **Seifert, Heinrich, Dr.**
**Dompfaffstrasse 40**
**W-8526 Bubenreuth(DE)**

(54) **Lötbare, supraleitende Leitung und Verwendung der Leitung.**

㊼ Die lötbare, supraleitende Leitung (2) für geringe Ströme hat eine Gesamtquerschnittsfläche (q) ihres elektrisch leitfähigen Teils von unter 0,1mm². Erfindungsgemäß enthält sie mindestens eine Trägerader (3, 4) aus normalleitendem Material, die von einer Hülle (5) aus einem lötbaren, supraleitenden Material vollständig umschlossen ist. Das lötbare Material enthält oder besteht aus Pb und/oder einer In-Legierung.

EP 0 497 183 A2

Die Erfindung bezieht sich auf eine lötbare, bei einer vorbestimmten Betriebstemperatur supraleitende Leitung mit einer Gesamtquerschnittsfläche ihres elektrisch leitfähigen Teils von unter 0,1 mm² sowie auf eine Verwendung dieser Leitung.

Für mikrotechnische supraleitende Meßeinrichtungen wie z.B. für Magnetfeldsensoren mit SQUIDs zur Messung biomagnetischer Felder (vgl. z.B. "Cryogenics", Vol.29, Aug. 1989, Seiten 809 bis 813) werden besondere Leitungen für kleine Ströme benötigt, die mit anderen Teilen der jeweiligen Meßeinrichtung elektrisch gut leitend zu verbinden sind. Außerdem müssen diese Leitungen bei einer durch eine Kühlung mit flüssigem Helium von 4,2K vorgegebenen Betriebstemperatur supraleitend sein. Als Materialien für solche Leitungen stehen prinzipiell Niob (Nb) und Blei (Pb) sowie Legierungen dieser Metalle mit anderen Elementen zur Verfügung. Da die Festigkeit von Drähten aus Pb bzw. Pb-Legierungen sehr gering ist, haben sich für bekannte technische Meßeinrichtungen hauptsächlich Drähte auf Nb-Basis durchgesetzt. Solche Drähte sind jedoch nur schwer lötbar und erfordern deshalb eine aufwendige Kontaktierungstechnik.

Supraleitende Schwachstromverbindungen mit Nb-Drähten werden normalerweise durch Schweißen, Crimpen oder Schrauben hergestellt. Schweißen ist dabei nur in einer speziellen Maschine und nicht am Einsatzort der Verbindung in einem Gerät möglich. Bei den anderen beiden Verbindungstechniken treten Probleme hinsichtlich eines großen Platzbedarfes auf, der für mikrotechnische supraleitende Meßeinrichtungen nicht tolerierbar ist.

Außerdem ist bei den genannten Verbindungstechniken eine direkte Verbindung zu supraleitend beschichteten, gedruckten Schaltungsteilen einer Meßeinrichtung nicht herstellbar.

Aufgabe der vorliegenden Erfindung ist es, eine supraleitende Leitung insbesondere für die bekannten mikrotechnischen supraleitenden Meßeinrichtungen anzugeben, die eine gute mechanische Festigkeit aufweist und leicht mit Teilen dieser Meßeinrichtung wie zum Beispiel speziellen Kontaktierungsflächen (Kontaktpads) zu verlöten ist.

Diese Aufgabe wird erfindungsgemäß dadurch gelöst, daß die Leitung mindestens eine Trägerader auf einem bei der Betriebstemperatur normalleitenden Material aufweist, die von einer Hülle aus einem lötbaren, bei der Betriebstemperatur supraleitenden Material vollständig umschlossen ist.

Die mit dieser Ausgestaltung der Leitung verbundenen Vorteile sind insbesondere darin zu sehen, daß für ihre supraleitende Hülle an sich bekannte supraleitende Lote, die insbesondere Pb oder eine Pb-Legierung oder eine Indium (In)-Legierung enthalten, verwendbar sind. Eine solche Leitung erhält ihre mechanische Stabilität vom Trägermaterial und ihre Supraleitfähigkeit von der Hülle (Überzug).

Wenn die Leitung in hochempfindliche Meßeinrichtungen wie z.B. in SQUID-Magnetometer eingesetzt werden soll, darf durch ihr normalleitendes Trägermaterial kein thermischer Rauschstrom in einen Meßkreis eingekoppelt werden. Da sich die normalleitenden Teile der erfindungsgemäßen Leitung in einer supraleitenden Umhüllung befinden, besteht diesbezüglich keine Gefahr. Das Innere eines Supraleiters ist nämlich magnetfeldfrei und damit stromlos, so daß vorteilhaft thermische Rauschströme des normalleitenden Trägermaterials der erfindungsgemäßen Leitung auf die innere Oberfläche ihrer supraleitenden Umhüllung beschränkt bleiben und nicht zu an ihre äußere Oberfläche angekoppelte Teile einer Meßeinrichtung gelangen können.

Besonders vorteilhaft ist die erfindungsgemäße Leitung für eine SQUID-Meßeinrichtung zu verwenden.

Vorteilhafte Ausgestaltungen der erfindungsgemäßen Leitung gehen aus den Unteransprüchen hervor.

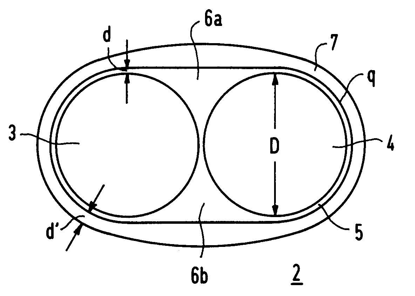

Zur weiteren Erläuterung der Erfindung wird nachfolgend auch auf die Zeichnung Bezug genommen, aus deren Figur eine erfindungsgemäße Leitung hervorgeht.

Es sind Lotmaterialien bekannt, die bei der Siedetemperatur des flüssigen Heliums (LHe) supraleitend sind (vgl. z.B. "Rev. Sci. Instrum.", Vol. 40, No. 1, Jan. 1969, Seiten 180 bis 182). Derartige Lotmaterialien bestehen aus oder enthalten insbesondere Pb und/oder In. Diesen Elementen kann mindestens ein weiteres Element insbesondere aus der Gruppe der Elemente Zinn (Sn), Wismut (Bi) und Cadmium (Cd) zulegiert sein. Entsprechende Ausführungsbeispiele sind spezielle In-Legierungen, insbesondere mit Sn-Komponente, sowie das bleihaltige Weichlot Pb40Sn60, das eine Sprungtemperatur $T_c$ von 7,05K hat und somit bei LHe-Temperatur supraleitend ist. Gemäß der Erfindung ist vorgesehen, eines dieser Materialien nicht nur als Lotmaterial, sondern auch als supraleitende Beschichtung eines normalleitenden Materials zu verwenden. Die einfachste Möglichkeit, eine supraleitende, lötbare Leitung nach der Erfindung herzustellen, besteht demnach darin, einen normalleitenden Draht, beispielsweise einen Draht aus Kupfer (Cu) oder einer Cu-Legierung oder aus Aluminium (Al) oder einer Al-Legierung mit dem Lotmaterial zu überziehen. Der normalleitende Draht dient dabei als Trägerader für das auf ihm aufgebrachte Lotmaterial.

Bei den meisten Anwendungen ist es unbedingt erforderlich, daß die Supraleitfähigkeit einer entsprechenden Leitung an keiner Stelle unterbrochen ist. Bei der vorbeschriebenen, einadrigen Ausführungsform der Leitung kann jedoch in Einzelfällen die Wahrscheinlichkeit verhältnismäßig groß sein, daß durch eine Beschädigung ihrer Oberfläche eine Unterbrechung des supraleitenden Strompfades auftritt. Es ist deshalb vorteilhaft, mehrere, mindestens jedoch zwei normalleitende Drähte als Trägeradern zu verwenden und mit einem hüllenartigen Überzug aus dem Lotmaterial zu verbinden. Insbesondere wegen der zwischen den Leiteradern mit Lotmaterial ausgefüllten, verhältnismäßig großflächigen Zwickel läßt sich so auch bei einer Beschädigung der Oberfläche der Leitung im Inneren ein supraleitender Pfad gewährleisten.

Da sich ferner das normalleitende Material der Trägeradern vollständig in einer supraleitenden Umhüllung befindet, sind vorteilhaft thermische Rauschströme der Leiteradern auf die innere Oberfläche der supraleitenden Umhüllung beschränkt und können so nicht zu an die äußere Oberfläche angekoppelte (anzulötende) Teile gelangen. Wird jedoch die Oberfläche beschädigt, so könnten Rauschströme austreten und sich negativ bemerkbar machen. Da die Rauschströme jedoch mit fallender Leitfähigkeit des normalleitenden Materials der Trägeradern kleiner werden, kann dem durch Wahl des Trägermaterials gegengesteuert werden. Vorteilhaft werden dehalb für die Trägeradern Legierungen gewählt, die sich einerseits gut mit dem supraleitenden Lotmaterial benetzen lassen, andererseits auch noch bei der durch das LHe festgelegten Betriebstemperatur eine geringe elektrische Leitfähigkeit besitzen. Ein Beispiel hierfür wäre eine Cu-Legierung wie Messing mit einem Überzug aus Pb oder einer Pb-Legierung.

In der Figur ist ein Ausführungsbeispiel einer allgemein mit 2 bezeichneten, feinlötbaren Leitung nach der Erfindung schematisch als Querschnitt veranschaulicht. Die insbesondere für eine SQUID-Meßeinrichtung verwendbare Leitung 2 enthält zwei normalleitende, drahtförmige Trägeradern 3 und 4. Der Durchmesser D dieser Adern liegt im allgemeinen unter $200\mu m$, beispielsweise bei $50\mu m$. Diese Adern sind vollständig von einer gemeinsamen Hülle 5 aus einem supraleitenden Lotmaterial wie z.B. Pb40Sn60 umschlossen. Die Dicke d dieser Hülle 5 liegt im Bereich der Trägeradern, d.h. außerhalb der zwischen den Trägeradern 3 und 4 ausgebildeten, mit Lotmaterial ausgefüllten Zwickel 6a und 6b, jeweils im allgemeinen unter $20\mu m$, beispielsweise zwischen 1 und 10 $\mu m$. Dieser Aufbau der Leitung 2 aus Trägeradern 3, 4 und Hülle 5 läßt sich insbesondere zur Verminderung der Gefahr von Beschädigungen zweckmäßig noch mit einem Überzug 7 aus einer Lackisolation versehen. Für diesen Lacküberzug 7 kommen insbesondere Materialien in Frage, die sich leicht und ohne Beschädigung der darunterliegenden Hülle 5 entfernen lassen, um so das Lotmaterial zur Verlötung mit anderen Teilen freizulegen. Entsprechende Lakke sind als "Lötlacke" bekannt und können z.B. leicht thermisch zersetzt werden (vgl. z.B. den Lackdraht mit dem Namen "Superflex V" der Firma "Lackdraht-Union GmbH", D 2838 Sulingen). Entsprechend aufgebaute, lackisolierte Drähte werden auch als "verzinnbare Lackdrähte" bezeichnet (vgl. z.B. das Buch "Kabel und Leitungen" des "Kombinat VEB Kabelwerk Oberspree", VEB Verlag Technik, Berlin 1989, Seiten 74, 75 und 147 bis 149). Die Dicke d' des Lacküberzugs 7 außerhalb der Zwickelbereiche liegt z.B. zwischen 10 und 20 $\mu m$ und kann in den Zwickelbereichen vergleichsweise etwas größer sein. Die Querschnittsfläche q des elektrisch leitfähigen Teils (ohne Lackdrahtüberzug) der Leitung 2 soll nicht über $0,1 mm^2$ hinausgehen, um eine hinreichende Flexibilität der gesamten Leitung gewährleisten zu können.

Entsprechende erfindungsgemäße Leitungen lassen sich vorteilhaft als supraleitende Schwachstromverbindungen insbesondere in Meßeinrichtungen wie SQUID-Magnetometern (vgl. die genannte Literaturstelle "Cryogenics") einsetzen, da dort die Anforderungen an die Stromtragfähigkeit der Leitungen verhältnismäßig gering sind und im allgemeinen nur kleine Ströme übertragen werden müssen, die z.B. unter 100mA, insbesondere unter 10mA, vorzugsweise unter 1mA liegen können. Andererseits erfordern insbesondere vielkanalige Meßeinrichtungen beispielsweise für ihre supraleitenden Flußtransformatoren eine große Anzahl solcher Leitungen, die leicht durch Verlöten kontaktierbar sein müssen. Es hat sich gezeigt, daß die erfindungsgemäßen Leitungen diese Anforderungen voll erfüllen können. Gemäß einem entsprechendem konkreten Ausführungsbeispiel wiesen die Leitungen jeweils einen Aufbau aus zwei Messing-Trägeradern 3, 4 und einer PbSn-Hülle 5 sowie eine zweifache Lackisolation auf. Bei LHe-Betriebstemperatur waren weder ein Widerstand noch ein thermisches Rauschen meßbar.

**Patentansprüche**

1.   Lötbare, bei einer vorbestimmten Betriebstemperatur supraleitende Leitung mit einer Gesamtquerschnittsfläche ihres elektrisch leitfähigen Teils von unter $0,1 mm^2$ , **gekennzeichnet durch** mindestens eine Trägerader (3, 4) aus einem bei der Betriebstemperatur normalleitenden Material, die von einer Hülle (5) aus einem lötbaren, bei der Betriebstemperatur supraleitenden Material vollständig umschlossen ist.

2.   Leitung nach Anspruch 1, **dadurch gekennzeichnet,** daß das lötbare, supraleitende Material Pb und/oder In zumindest enthält.

3. Leitung nach Anspruch 2, **dadurch gekennzeichnet,** daß das lötbare, supraleitende Material als eine weitere Komponente mindestens eines der Elemente Sn oder Bi oder Cd enthält.

4. Leitung nach einem der Ansprüche 1 bis 3, **dadurch gekennzeichnet,** daß die mindestens eine Trägerader (3, 4) aus Cu oder einer Cu-Legierung oder aus Al oder einer Al-Legierung besteht.

5. Leitung nach Anspruch 4, **dadurch gekennzeichnet,** daß als Material für die mindestens eine Trägerader (3, 4) Messing vorgesehen ist.

6. Leitung nach einem der Ansprüche 1 bis 5**, dadurch gekennzeichnet,** daß mehrere Trägeradern (3, 4) von dem lötbaren, supraleitenden Material (5) umhüllt sind, von denen jede Ader eine Querschnittsfläche unter 0,04 mm$^2$ aufweist.

7. Leitung nach einem der Ansprüche 1 bis 6, **gekennzeichnet durch** einen Überzug (7) aus einem Lack, der im Bereich einer herzustellenden Lötverbindung entfernt ist.

8. Verwendung der Leitung nach einem der Ansprüche 1 bis 7 für eine SQUID-Meßeinrichtung.